# EUROPÄISCHE PATENTSCHRIFT

(11) **EP 2 415 077 B1**
(45) Veröffentlichungstag und Bekanntmachung des Hinweises auf die Patenterteilung: **11.10.2017**
(21) Anmeldenummer: 10706666.4
(22) Anmeldetag: 05.03.2010
(51) Int. Cl.: H01L 33/62, H01L 31/0203, H01L 31/02, H01L 27/146, H01L 33/54, H01L 33/48, H01L 23/00

(54) **OPTOELEKTRONISCHES BAUELEMENT**
OPTOELECTRONIC COMPONENT
COMPOSANT OPTOÉLECTRONIQUE

(30) Priorität: 02.04.2009 DE 102009015963
(43) Veröffentlichungstag der Anmeldung: 08.02.2012
(73) Patentinhaber: OSRAM Opto Semiconductors GmbH, 93055 Regensburg (DE)
(72) Erfinder: RAMCHEN, Johann, 84032 Altdorf (DE); ZITZLSPERGER, Michael, 93047 Regensburg (DE)
(74) Vertreter: Epping - Hermann - Fischer
(86) Internationale Anmeldenummer: PCT/EP2010/052850
(87) Internationale Veröffentlichungsnummer: WO 2010/112298

(56) Entgegenhaltungen:
- EP-A1- 0 562 550
- WO-A1-2008/056813
- US-A1- 2004 200 951
- US-A1- 2006 086 899
- US-A1- 2008 237 767

## Beschreibung

Es wird ein optoelektronisches Bauelement mit einem optoelektronischen Halbleiterchip angegeben, der drahtlos elektrisch angeschlossen ist.

Diese Patentanmeldung beansprucht die Priorität der deutschen Patentanmeldung 10 2009 015 9630. In der Patentschrift DE 103 39 985 B4 ist ein optoelektronisches Bauelement mit einem optoelektronischen Halbleiterchip beschrieben, der auf einer Strahlungsaustrittsseite mittels einer leitfähigen transparenten Schicht, die auf einer Trägerfolie aufgebracht ist, drahtlos elektrisch angeschlossen ist. Diese Art der Folienkontaktierung erweist sich insofern als aufwändig, da zwischen der transparenten Schicht und dem Halbleiterchip bereichsweise eine Isolierschicht vorgesehen werden muss, um einen Kurzschluss innerhalb des Bauelements zu vermeiden. Die Patentschrift WO2008/056813 A1 beschreibt ein optoelektronisches Bauelement, bei dem die Kontaktierung des optoelektronischen Halbeiterchips mittels eines mit einer Vertiefung versehenen Anschlusselements, drahtlos, erfolgt.

Eine zu lösende Aufgabe besteht vorliegend darin, ein optoelektronisches Bauelement mit einem optoelektronischen Halbleiterchip anzugeben, der auf einfache Weise drahtlos elektrisch angeschlossen ist.

Diese Aufgabe wird durch ein optoelektronisches Bauelement gemäß Patentanspruch 1 gelöst.

Vorteilhafte Ausgestaltungen und Weiterbildungen des optoelektronischen Bauelements sind in den abhängigen Ansprüchen angegeben.

Gemäß einer bevorzugten Ausführungsform weist das optoelektronische Bauelement einen optoelektronischen Halbleiterchip, einen Kontaktrahmen, einen Kontaktträger sowie einen ersten elektrischen Anschlussbereich und einen von dem ersten elektrischen Anschlussbereich elektrisch isolierten zweiten elektrischen Anschlussbereich auf. Die beiden Anschlussbereiche umfassen jeweils einen Teil des Kontaktrahmens und einen Teil des Kontaktträgers, wobei der Kontaktrahmen mit einer Vertiefung versehen ist, welche den ersten elektrischen Anschlussbereich zumindest bereichsweise von dem zweiten elektrischen Anschlussbereich trennt und in welche der optoelektronische Halbleiterchip hineinragt, und wobei der Kontaktrahmen mit einem Kontaktelement ausgebildet ist, das den Kontaktrahmen mit dem optoelektronischen Halbleiterchip elektrisch verbindet.

Der optoelektronische Halbleiterchip kann ein Strahlung emittierender oder ein Strahlung empfangender Halbleiterchip sein. Der optoelektronische Halbleiterchip weist eine dem Kontaktelement zugewandte Strahlungsdurchtrittsfläche auf, wobei die Strahlungsdurchtrittsfläche im Falle eines Strahlung emittierenden Halbleiterchips eine Strahlungsaustrittsfläche und im Falle eines Strahlung empfangenden Halbleiterchips eine Strahlungseintrittsfläche ist.

Die Strahlungsdurchtrittsfläche ist vorzugsweise mit dem Kontaktelement des Kontaktrahmens verbunden. Insbesondere ragt das Kontaktelement in die Vertiefung des Kontaktrahmens hinein, während der restliche Kontaktrahmen die Vertiefung begrenzt. Der optoelektronische Halbleiterchip ist in der Vertiefung vorzugsweise derart angeordnet, dass die durch die Strahlungsdurchtrittsfläche hindurchtretende Strahlung zwar auf das Kontaktelement, im Wesentlichen jedoch nicht auf den restlichen Kontaktrahmen auftreffen kann. Somit können Strahlungsverluste, die durch Abschattung am Kontaktrahmen hervorgerufen werden, gering gehalten werden.

Durch den ersten und zweiten elektrischen Anschlussbereich ist eine elektrische Versorgung des optoelektronischen Halbleiterchips möglich. Mit Vorteil weisen sowohl der Kontaktrahmen als auch der Kontaktträger, aus welchen sich die beiden Anschlussbereiche zusammensetzen, ein elektrisch leitendes Material auf.

Vorzugsweise ist der optoelektronische Halbleiterchip ein Strahlung emittierender Halbleiterchip. Zur Strahlungserzeugung weist der optoelektronische Halbleiterchip eine aktive Zone mit einem pn-Übergang auf, der im einfachsten Falle aus einer p-leitenden und einer n-leitenden Halbleiterschicht gebildet ist, die unmittelbar aneinandergrenzen. Bevorzugt ist zwischen der p-leitenden und der n-leitenden Halbleiterschicht die eigentliche Strahlung erzeugende Schicht, etwa in Form einer dotierten oder undotierten Quantenschicht, ausgebildet. Die Quantenschicht kann als Einfachquantentopfstruktur (SQW, Single Quantum Well) oder Mehrfachquantentopfstruktur (MQW, Multiple Quantum Well) oder auch als Quantendraht oder Quantenpunktstruktur ausgebildet sein.

Gemäß einer vorteilhaften Ausgestaltung ist das Kontaktelement ein Teil des ersten Anschlussbereichs und verbindet den optoelektronischen Halbleiterchip mit dem ersten Anschlussbereich drahtlos.

Beispielsweise kann das Kontaktelement streifenartig ausgebildet sein. Das Kontaktelement liegt mit Vorteil auf der Strahlungsdurchtrittsfläche auf. Zwischen dem Halbleiterchip und dem Kontaktelement kann ein elektrisch leitendes Mittel vorgesehen sein, zum Beispiel ein Lötmittel oder Klebemittel, welches das Kontaktelement mit dem Halbleiterchip elektrisch verbindet.

Weiterhin kann der optoelektronische Halbleiterchip auf dem Kontaktträger des zweiten Anschlussbereichs angeordnet sein. Hierbei ist der optoelektronische Halbleiterchip insbesondere mit dem Kontaktträger drahtlos elektrisch verbunden. Mittels Die-Bonden kann der Halbleiterchip auf dem Kontaktträger befestigt werden.

Bei einer bevorzugten Ausführungsform sind der Kontaktrahmen und der Kontaktträger einstückig ausgebildet. Beispielsweise können der Kontaktrahmen und der Kontaktträger einstückig aus einem einzigen Werkstück wie einem Metallblech gebildet sein. Das Werkstück wird mit Vorteil derart strukturiert, dass es eine Vertiefung für den Halbleiterchip und ein Kontaktelement zur elektrischen Kontaktierung des Halbleiterchips aufweist. Ferner wird das Werkstück derart zerteilt, dass infolge ein erster und zweiter Anschlussbereich vorhanden sind. Die einstückige Ausbildung von Kontaktrahmen und Kontaktträger ermöglicht eine einfache Herstellung des ersten und zweiten Anschlussbereichs.

Bei einer weiteren Ausführungsform sind der Kontaktrahmen und der Kontaktträger zwei separate Elemente. Diese Ausführungsform hat beispielsweise den Vorteil, dass zwischen Kontaktrahmen und Kontaktträger bereichsweise ein elektrisch isolierendes Mittel angeordnet werden kann, so dass der Kontaktrahmen in dem Bereich, wo sich das elektrisch isolierende Mittel befindet, von dem Kontaktträger elektrisch isoliert ist. Somit ist es beispielsweise möglich, einen ersten und zweiten Anschlussbereich mit einem gemeinsamen Kontaktträger auszubilden, der sich durchgehend vom ersten Anschlussbereich bis zum zweiten Anschlussbereich erstreckt.

Insbesondere ist der Kontaktrahmen auf dem Kontaktträger angeordnet. Vorzugsweise ist der Kontaktrahmen mit dem Kontaktträger unlösbar verbunden. Mit Vorteil ist der Kontaktrahmen zumindest bereichsweise durch ein elektrisch leitendes Mittel mit dem Kontaktträger verbunden. Beispielsweise kann der Kontaktrahmen auf den Kontaktträger geklebt, eutektisch gebondet oder gelötet sein.

Gemäß einer bevorzugten Ausgestaltung ist der Kontaktrahmen aus einem einzigen Werkstück, vorzugsweise aus einem Metallblech, gebildet. Das Werkstück wird mit Vorteil derart strukturiert, dass es eine Vertiefung für den Halbleiterchip und ein Kontaktelement zur elektrischen Kontaktierung des Halbleiterchips aufweist.

Entsprechend dem Kontaktrahmen kann auch der Kontaktträger aus einem einzigen Werkstück, vorzugsweise aus einem Metallblech, gebildet sein. Das Werkstück wird mit Vorteil derart strukturiert, dass es eine Vertiefung für den Halbleiterchip aufweist, auf deren Boden der Halbleiterchip befestigt werden kann.

Alternativ kann der Kontaktträger ein Substrat mit mindestens einem elektrisch leitenden Bereich aufweisen. Der mindestens eine elektrisch leitende Bereich des Kontaktträgers bildet in Verbindung mit dem Kontaktrahmen den ersten oder zweiten elektrischen Anschlussbereich. Das Substrat kann ein elektrisch leitendes oder geringfügig leitendes Material oder ein elektrisch isolierendes Material enthalten. Besonders geeignet ist ein Material mit guter Wärmeleitfähigkeit zur ausreichenden Kühlung des Halbleiterchips. Beispielsweise kann das Substrat ein Keramikmaterial, ein Halbleitermaterial oder ein Kunststoffmaterial enthalten. Im Falle eines geringfügig elektrisch leitenden oder elektrisch isolierenden Substrats kann der mindestens eine elektrisch leitende Bereich durch Aufbringen einer Metallisierung auf das Substrat hergestellt werden. Im Falle eines elektrisch leitenden Substrats kann das Substrat bereichsweise mit einem elektrisch isolierenden Material bedeckt werden, so dass der von dem elektrisch isolierenden Material unbedeckte Bereich des Substrats den elektrisch leitenden Bereich bildet.

Gemäß einer bevorzugten Ausgestaltung des optoelektronischen Bauelements ist der Verbund aus optoelektronischem Halbleiterchip, Kontaktrahmen und Kontaktträger in eine Umhüllung eingebettet. Ein derartig kompakter Aufbau erfordert vorteilhafterweise kein zusätzliches Gehäuse.

Die Umhüllung kann aus einer Vergussmasse oder einer Spritzgussmasse hergestellt werden. Vorzugsweise enthält die Umhüllung ein Silikon.

Bei einer weiteren Ausgestaltung des optoelektronischen Bauelements weist der Kontaktrahmen auf einer dem Kontaktträger zugewandten oder abgewandten Seite außer der Vertiefung für den Halbleiterchip weitere Vertiefungen auf. Insbesondere sind die weiteren Vertiefungen mit dem Umhüllungsmaterial gefüllt. Auf diese Weise kann die Umhüllung im Kontaktrahmen verankert werden.

Gemäß einer bevorzugten Weiterbildung weist die Umhüllung eine zur Strahlformung vorgesehene optische Struktur auf. Ausgehend vom optoelektronischen Halbleiterchip ist die optische Struktur dem Kontaktrahmen nachgeordnet. Beispielsweise kann die Umhüllung eine konvex gekrümmte Oberfläche aufweisen, so dass die optische Struktur eine konvexe Linse ist, welche die hindurchtretende Strahlung bündelt.

Weiterhin kann das optoelektronische Bauelement zusätzlich zu dem optoelektronischen Halbleiterchip einen weiteren Halbleiterchip aufweisen. Ferner weist der Kontaktrahmen mit Vorteil ein weiteres Kontaktelement auf, das mit dem weiteren Halbleiterchip verbunden ist. Der optoelektronische Halbleiterchip kann mit dem weiteren Halbleiterchip seriell, parallel oder antiparallel verschaltet sein. Beispielsweise ist der weitere Halbleiterchip ein Strahlung emittierender oder Strahlung empfangender Halbleiterchip oder eine Schutzdiode.

Gemäß einer bevorzugten Variante eines Verfahrens zur Herstellung des optoelektronischen Bauelements wird dieses in Serie gerfertigt. Hierfür werden insbesondere eine Kontaktrahmeneinheit, die mehrere Kontaktrahmen für mehrere optoelektronische Bauelemente aufweist, sowie eine Kontaktträgereinheit, die mehrere Kontaktträger für mehrere optoelektronische Bauelemente aufweist, verwendet. Die Einheit aus Halbleiterchips, Kontaktrahmen- und trägereinheit wird derart vereinzelt, dass nach der Vereinzelung mehrere optoelektronische Bauelemente vorliegen.

Bei einer vorteilhaften Variante des Verfahrens werden für die Kontaktrahmeneinheit und die Kontaktträgereinheit zwei separate Elemente bereitgestellt.

Die Kontaktrahmeneinheit kann aus einem einzigen Werkstück hergestellt werden. Insbesondere wird als Werkstück ein Metallblech verwendet.

Vorzugsweise wird das Werkstück mit Vertiefungen versehen, die sich von einer ersten Hauptfläche bis zu einer der ersten Hauptfläche gegenüber liegenden zweiten Hauptfläche des Werkstücks durchgehend erstrecken. In den Vertiefungen kann jeweils mindestens ein Halbleiterchip angeordnet werden. Zur Ausbildung der durchgehenden Vertiefungen kann das Werkstück ausgehend von der ersten Hauptfläche teilweise geätzt werden und entsprechend von der zweiten Hauptfläche aus teilweise geätzt werden. Außerdem wird jeweils mindestens ein Kontaktelement hergestellt, das in die Vertiefung hineinragt.

Weitere Vertiefungen zur Verankerung einer Umhüllung können ausgehend von der ersten oder zweiten Hauptfläche in das Werkstück geätzt werden, wobei sich die Vertiefungen nicht vollständig durch das Werkstück hindurch erstrecken müssen.

Die Kontaktträgereinheit kann auf zwei verschiedene Arten hergestellt werden. Eine erste Möglichkeit besteht darin, die Kontaktträgereinheit aus einem einzigen Werkstück herzustellen, das insbesondere ein Metallblech ist. Eine zweite Möglichkeit besteht darin, für die Kontaktträgereinheit ein Substrat zu vewenden, das elektrisch leitende Bereiche aufweist.

Wird die Kontaktträgereinheit aus einem einzigen Werkstück hergestellt, so werden in dem Werkstück vorzugsweise Vertiefungen ausgebildet, auf deren Boden jeweils mindestens ein Halbleiterchip befestigt werden kann. Die Vertiefungen können ausgehend von einer ersten Hauptfläche des Werkstücks in dieses geätzt werden.

Ferner können ausgehend von der ersten oder einer zweiten Hauptfläche des Werkstücks, die der ersten Hauptfläche gegenüber liegt, weitere Vertiefungen zur Verankerung einer Umhüllung in das Werkstück geätzt werden, die sich teilweise oder vollständig durch das Werkstück hindurch erstrecken.

Wird für die Kontaktträgereinheit ein Substrat mit elektrisch leitenden Bereichen verwendet, so enthält das Substrat mit Vorteil ein Keramikmaterial, ein Halbleitermaterial oder ein Kunststoffmaterial. Auf eine Hauptfläche des Substrats wird insbesondere eine elektrisch leitende Beschichtung, vorzugsweise eine Metallisierung, bereichsweise aufgebracht, so dass das Substrat auf der Hauptfläche elektrisch leitende Bereiche aufweist.

Auf der Kontaktträgereinheit werden die Halbleiterchips auf den dafür vorgesehenen Bereichen befestigt. Dies kann seriell oder in einem batch-Prozess erfolgen. Insbesondere werden die Halbleiterchips auf die Kontaktträgereinheit gelötet.

Dann wird die Kontaktrahmeneinheit auf die Kontaktträgereinheit aufgesetzt. Dabei kann die Kontaktrahmeneinheit zusammenhängende Kontaktrahmen oder separate Kontaktrahmen aufweisen, die stückweise auf die Kontaktträgereinheit aufgesetzt werden. Ferner kann die Kontaktträgereinheit zusammenhängende Kontaktträger oder separate Kontaktträger aufweisen.

Die Kontaktrahmeneinheit wird mit der Kontaktträgereinheit zumindest bereichsweise elektrisch leitend verbunden. Die Kontaktrahmeneinheit kann auf die Kontaktträgereinheit geklebt, eutektisch gebondet oder gelötet werden.

Mit Vorteil wird die Kontaktrahmeneinheit so auf die Kontaktträgereinheit aufgesetzt, dass die Halbleiterchips in die jeweiligen für diese vorgesehene Vertiefungen der Kontaktrahmen hineinragen. Insbesondere ragen die Halbleiterchips in die entsprechenden Vertiefungen soweit hinein, dass sie mit dem Kontaktelement des Kontaktrahmens in Kontakt stehen. Somit können die Halbleiterchips durch Aufsetzen der Kontaktrahmeneinheit auf die Kontaktträgereinheit elektrisch kontaktiert werden. Zur Unterstützung der elektrischen Verbindung kann zwischen Halbleiterchip und Kontaktelement ein elektrisch leitendes Mittel, beispielsweise ein Leitkleber oder eine Lötverbindung, angeordnet werden.

Gemäß einer weiteren Variante des Verfahrens werden die Kontaktrahmeneinheit und die Kontaktträgereinheit einstückig hergestellt. Insbesondere wird hierfür ein einziges Werkstück, beispielsweise ein Metallblech, verwendet. Die Ausbildung der Vertiefungen für die Halbleiterchips sowie der weiteren Vertiefungen zur Verankerung einer Umhüllung können wie im Falle der oben beschriebenen zweistückigen Herstellung der Kontaktrahmeneinheit und der Kontaktträgereinheit erfolgen.

Bei allen beschriebenen Varianten eines Verfahrens kann der Verbund aus Kontaktrahmeneinheit, Kontaktträgereinheit und Halbleiterchips in eine Umhüllung eingebettet werden, die insbesondere ein Silikon enthält. Dies kann beispielsweise durch Vergießen oder Spritzguss erfolgen.

Vorteilhafte Ausführungsformen eines optoelektronischen Bauelements werden im folgenden anhand der Figuren 1 bis 4 näher erläutert.

Es zeigen:
- Figur 1: eine schematische Querschnittsansicht eines ersten Ausführungsbeispiels eines optoelektronischen Bauelements,
- Figur 2: eine schematische Aufsicht auf ein zweites Ausführungsbeispiel eines optoelektronischen Bauelements,
- Figur 3: eine schematische Querschnittsansicht eines dritten Ausführungsbeispiels eines optoelektronischen Bauelements,
- Figur 4: eine schematische Aufsicht auf ein viertes Ausführungsbeispiel eines optoelektronischen Bauelements.

Gleiche oder gleichwirkende Elemente sind in den Figuren mit den gleichen Bezugszeichen versehen.

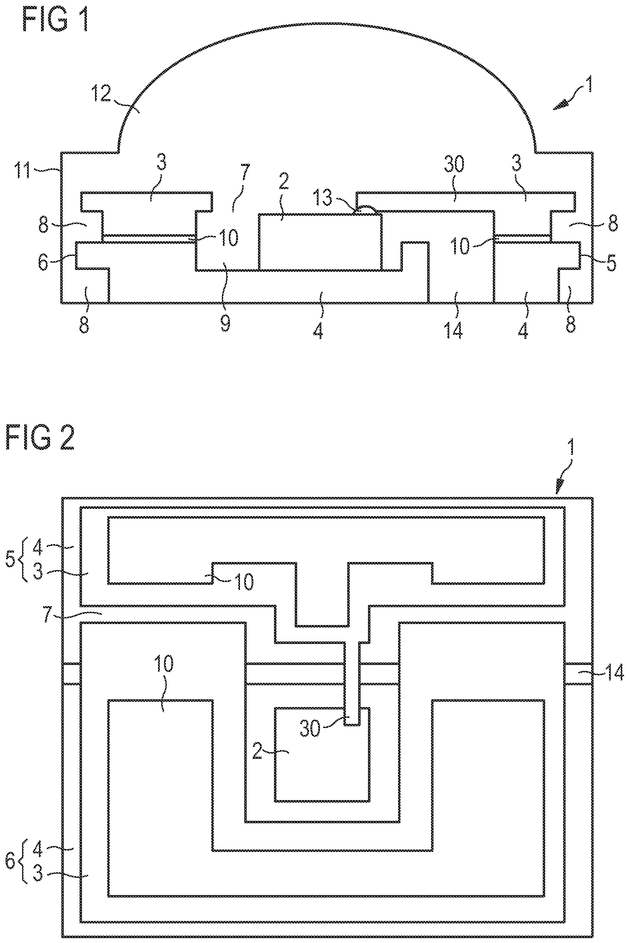

In Figur 1 ist ein optoelektronisches Bauelement 1 dargestellt, das einen optoelektronischen Halbleiterchip 2 sowie einen Kontaktrahmen 3 und einen Kontaktträger 4 aufweist. Vorzugsweise ist der optoelektronische Halbleiterchip 2 ein Strahlung erzeugender Halbleiterchip.

Der Kontaktrahmen 3 und der Kontaktträger 4 sind separate Elemente, wobei der Kontaktrahmen 3 zumindest bereichsweise durch ein elektrisch leitendes Mittel 10 auf dem Kontaktträger 4 befestigt ist. Beispielsweise kann der Kontaktrahmen 3 auf den Kontaktträger 4 geklebt, eutektisch gebondet oder gelötet sein.

Der Kontaktrahmen 3 und der Kontaktträger 4 enthalten ein elektrisch leitendes Material. Insbesondere sind der Kontaktrahmen 3 und der Kontaktträger 4 jeweils aus einem Metallblech gebildet.

Sowohl der Kontaktrahmen 3 als auch der Kontaktträger 4 sind zweiteilig ausgebildet. Hierfür ist der Kontaktrahmen 3 mit einer Vertiefung 7 versehen, welche den Kontaktrahmen 3 in zwei Teile trennt. Ebenso weist der Kontaktträger 4 eine Vertiefung 14 auf, welche den Kontaktträger 4 in zwei Teile trennt.

Ein erster Teil des Kontaktrahmens 3 bildet zusammen mit einem ersten Teil des Kontaktträgers 4 einen ersten Anschlussbereich 5. Weiterhin bildet ein zweiter Teil des Kontaktrahmens 3 zusammen mit einem zweiten Teil des Kontaktträgers 4 einen zweiten Anschlussbereich 6. Durch die Vertiefungen 7 und 14, in welchen sich ein elektrisch isolierendes Medium befindet, ist der erste Anschlussbereich 5 von dem zweiten Anschlussbereich 6 elektrisch isoliert.

Auf einer dem Kontaktrahmen 3 zugewandten Seite des Kontaktträgers 4 ist eine Vertiefung 9 ausgebildet, auf deren Boden der optoelektronische Halbleiterchip 2 mit seiner Rückseite angeordnet ist. Insbesondere ist der optoelektronische Halbleiterchip 2 mit dem Kontaktträger 4 elektrisch leitend verbunden. Der optoelektronische Halbleiterchip 2 kann auf den Kontaktträger 4 gelötet sein. Der Halbleiterchip 2 ist auf diese Weise mit dem zweiten Anschlussbereich 6 drahtlos elektrisch verbunden.

Der optoelektronische Halbleiterchip 2 ragt mit seiner Vorderseite in die Vertiefung 7 des Kontaktrahmens 3 hinein. Der Halbleiterchip 2 ragt soweit in die Vertiefung 7 hinein, dass eine Strahlungsdurchtrittsfläche des Halbleiterchips 2 mit einem Kontaktelement 30 des Kontaktrahmens 3 in Kontakt steht. Zwischen dem Kontaktelement 30 und dem Halbleiterchip 2 ist ein elektrisch leitendes Mittel 13 angeordnet, welches das Kontaktelement 30 und den Halbleiterchip 2 elektrisch verbindet. Somit ist der optoelektronische Halbleiterchip 2 mit dem ersten Anschlussbereich 5 drahtlos elektrisch verbunden.

Die Vertiefung 7 ist insbesondere so dimensioniert, dass die Strahlungsdurchtrittsfläche des Halbleiterchips 2 von dem Kontaktrahmen 3 unbedeckt ist, so dass von dem Halbleiterchip 2 erzeugte Strahlung ungehindert durch die Vertiefung 7 hindurchtreten und aus dem optoelektronischen Bauelement 1 auskoppeln kann. Das Kontaktelement 30 des Kontaktrahmens 3 bedeckt einen vernachlässigbar kleinen Teil der Strahlungsdurchtrittsfläche des Halbleiterchips 2.

Umfangseitig ist der Halbleiterchip 2 größtenteils von dem ersten und zweiten Anschlussbereich 5, 6 umgeben, so dass seitlich emittierte Strahlung auf den ersten oder zweiten Anschlussbereich 5, 6 auftreffen, in Richtung der Vertiefung 7 reflektiert und aus dem optoelektronischen Bauelement 1 ausgekoppelt werden kann.

Der Verbund aus optoelektronischem Halbleiterchip 2, Kontaktrahmen 3 und Kontaktträger 4 ist in eine Umhüllung 11 eingebettet. Auf ein zusätzliches Gehäuse kann vorteilhafterweise verzichtet werden. Die Umhüllung 11 enthält insbesondere ein strahlungsdurchlässiges elektrisch isolierendes Material wie Silikon.

Der Kontaktrahmen 3 und der Kontaktträger 4 weisen auf ihren Unterseiten weitere Vertiefungen 8 auf, die vorzugsweise mit dem Umhüllungsmaterial gefüllt sind. Durch diese Vertiefungen 8 kann die Umhüllung 11 im Kontaktrahmen 3 und im Kontaktträger 4 verankert werden.

Ferner sind auch die Vertiefungen 7 und 9 mit dem Umhüllungsmaterial gefüllt, so dass der Halbleiterchip 2 geschützt ist. Weiterhin ist auch die Vertiefung 14 mit dem Umhüllungsmaterial gefüllt. Durch das in den Vertiefungen 7 und 14 angeordnete elektrisch isolierende Umhüllungsmaterial sind der erste und zweite Anschlussbereich 5, 6 voneinander elektrisch isoliert.

Die Umhüllung 11 weist eine zur Strahlformung vorgesehene optische Struktur 12 auf. Ausgehend vom optoelektronischen Halbleiterchip 2 ist die optische Struktur 12 dem Kontaktrahmen 3 nachgeordnet. Die Umhüllung 11 weist eine konvex gekrümmte Oberfläche auf, so dass die optische Struktur 12 eine konvexe Linse ist, welche die hindurchtretende Strahlung bündelt.

Figur 2 zeigt ein weiteres Ausführungsbeispiel eines optoelektronischen Bauelements 1 in Aufsicht. Der optoelektronische Halbleiterchip 2 ist auf einer dafür vorgesehenen Montagefläche des Kontaktträgers 4 angeordnet. Der Kontaktträger 4 ist zweiteilig ausgebildet, wobei die beiden Teile des Kontaktträgers 4 durch die Vertiefung 14 voneinander getrennt sind. Zur elektrischen Isolierung der beiden Teile ist die Vertiefung 14 mit einem elektrisch isolierenden Material, insbesondere einem Kunststoffmaterial, gefüllt. Die beiden Teile des Kontaktträgers 4 weisen einen rechteckförmigen Grundriss auf.

Auf dem Kontaktträger 4 ist der Kontaktrahmen 3 angeordnet. Auch der Kontaktrahmen 3 ist zweiteilig ausgebildet, wobei die beiden Teile des Kontaktrahmens 3 durch die Vertiefung 7 voneinander getrennt sind. Der dem zweiten Anschlussbereich 6 zugeordnete Teil des Kontaktrahmens 3 umgibt den Halbleiterchip 2 U-förmig. Der dem ersten Anschlussbereich 5 zugeordnete Teil des Kontaktrahmens 3 ergänzt den U-förmigen Teil derart, dass der Halbleiterchip 2 auf allen vier Seiten von dem Kontaktrahmen 3 umgeben ist. Dieser Teil des Kontaktrahmens 3 weist das Kontaktelement 30 auf, das auf der Strahlungsdurchtrittsfläche des Halbleiterchips 2 aufliegt und den Halbleiterchip 2 mit dem ersten Anschlussbereich 5 drahtlos elektrisch verbindet.

Vorzugsweise sind sowohl der Kontaktrahmen 3 als auch der Kontaktträger 4 aus einem einzigen Werkstück insbesondere einem Metallblech, hergestellt.

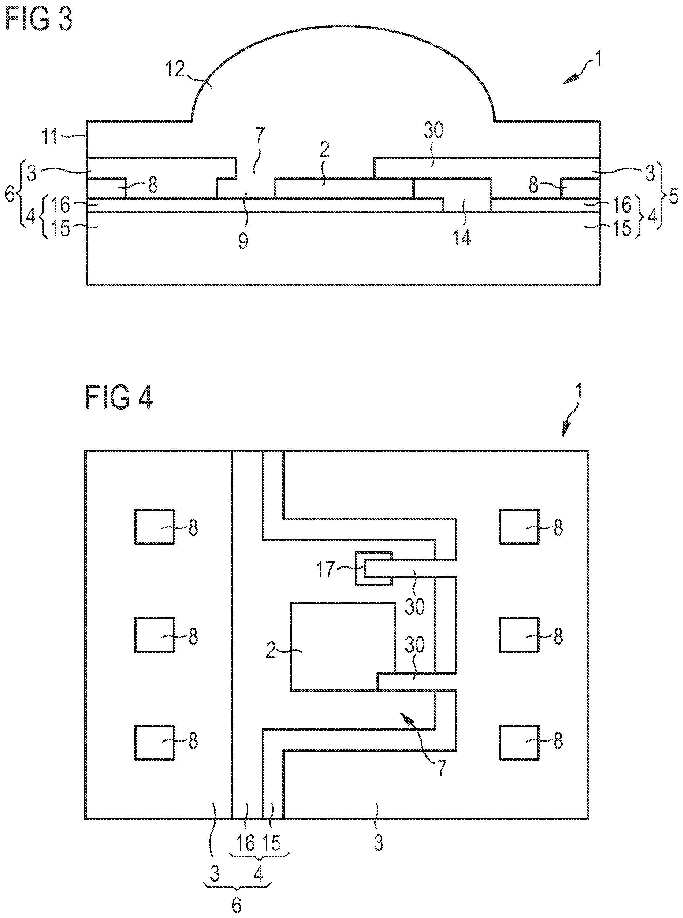

In Figur 3 ist ein Ausführungsbeispiel eines optoelektronischen Bauelements 1 dargestellt, bei welchem der Kontaktträger 4 nicht aus einem einzigen Werkstück hergestellt ist. Der Kontaktträger 4 weist ein Substrat 15 mit zwei durch die Vertiefung 14 voneinander getrennten elektrisch leitenden Bereichen 16 auf. Das Substrat 15 ist vorzugsweise nur geringfügig oder nicht elektrisch leitend. Es kann beispielsweise ein Keramikmaterial, ein Halbleitermaterial oder ein Kunststoffmaterial enthalten. Das Substrat 15 ist mit einer Metallisierung beschichtet, die so strukturiert ist, dass sie die beiden voneinander getrennten elektrisch leitenden Bereiche 16 aufweist.

Auf dem Kontaktträger 4 ist der Kontaktrahmen 3 angeordnet. Dieser ist entsprechend dem in Figur 1 dargestellten Kontaktrahmen 3 ausgebildet, das heißt er ist vorzugsweise aus einem einzigen Werkstück, insbesondere einem Metallblech, hergestellt. Der Kontaktrahmen 3 ist so auf dem Kontaktträger 4 aufgesetzt, dass der erste Teil des zweitteilig ausgebildeten Kontaktrahmens 3 nur mit dem einen elektrisch leitenden Bereich 16 des Kontaktträgers 4 und der zweite Teil nur mit dem anderen elektrisch leitenden Bereich 16 des Kontaktträgers 4 in Verbindung steht.

Hinsichtlich der weiteren Ausgestaltungen gleicht das in Figur 3 dargestellte optoelektronische Bauelement 1 dem in Figur 1 dargestellten optoelektronischen Bauelement 1.

Figur 4 zeigt ein weiteres Ausführungsbeispiel eines optoelektronischen Bauelements 1, dessen Kontaktträger 4 entsprechend dem in Figur 3 dargestellten Bauelement 1 ein Substrat 15 mit voneinander getrennten elektrisch leitenden Bereichen 16 (nur ein Bereich ist zu sehen) aufweist.

Der Kontaktrahmen 3 ist vorzugsweise aus einem einzigen Werkstück, insbesondere einem Metallblech, gebildet. Der Kontaktrahmen 3 weist Vertiefungen 8 auf, die sich von einer dem Kontaktträger 4 abgewandten ersten Hauptfläche bis zu einer der ersten Hauptfläche gegenüber liegenden Hauptfläche des Kontaktrahmens 3 erstrecken. Diese Vertiefungen 8 sind zur Verankerung einer Umhüllung (nicht dargestellt) geeignet.

Neben dem optoelektronischen Halbleiterchip 2 weist das optoelektronische Bauelement 1 einen weiteren Halbleiterchip 17 auf. Der Halbleiterchip 17 ist bei diesem Ausführungsbeispiel eine Schutzdiode, deren pn-Übergang im Vergleich zu dem pn-Übergang des optoelektronischen Halbleiterchips 2 gegensinnig angeordnet ist.

Der Kontaktrahmen 3 weist außer dem für den optoelektronischen Halbleiterchip 2 vorgesehenen Kontaktelement 30 ein weiteres Kontaktelement 30 auf, das eine Oberseite des weiteren Halbleiterchips 17 mit dem Kontaktrahmen 3 des ersten Anschlussbereichs elektrisch leitend verbindet. Der Kontaktrahmen 3 weist zwischen den beiden Kontaktelementen keine Unterbrechung auf, so dass die beiden Halbleiterchips 2, 17 über den Kontaktrahmen 3 im Betrieb mit demselben Potential beaufschlagt sind.

Mit ihrer Unterseite sind die beiden Halbleiterchips 2, 17 auf einem Teil des elektrisch leitenden Bereichs 16 angeordnet, der in die Vertiefung 7 hineinragt. Dieser Teil des elektrisch leitenden Bereichs 16 weist eine an die Rechteckform der Halbleiterchips 2 angepasste, ebenfalls rechteckige Form auf. Diese Form lässt sich bei diesem Ausführungsbeispiel durch geeignete Strukturierung der Metallisierung, aus welcher der elektrisch leitende Bereich 16 vorzugsweise hergestellt ist, leichter realisieren als bei einem Kontaktträger, der aus einem massiven Werkstück hergestellt ist.

Die Unterseite der beiden Halbleiterchips 2, 17 ist mit dem elektrisch leitenden Bereich 16 elektrisch verbunden. Der elektrisch leitende Bereich 16 weist zwischen den Halbleiterchips 2, 17 keine Unterbrechung auf, so dass die beiden Halbleiterchips 2, 17 über den elektrisch leitenden Bereich 16 und den mit diesem verbundenen Kontaktrahmen 3 des zweiten Anschlussbereichs 6 im Betrieb mit demselben Potential beaufschlagt sind.

Somit sind die beiden Halbleiterchips 2, 17 bei diesem Ausführungsbeispiel im Betrieb antiparallel verschaltet.

Die Erfindung ist nicht durch die Beschreibung anhand der Ausführungsbeispiele beschränkt. Vielmehr umfasst die Erfindung jede Kombination von Merkmalen in den Patentansprüchen.

## Patentansprüche

1. Optoelektronisches Bauelement (1) aufweisend
- einen optoelektronischen Halbleiterchip (2),
- einen Kontaktrahmen (3),
- einen Kontaktträger (4),
- einen ersten elektrischen Anschlussbereich (5) und einen von dem ersten elektrischen Anschlussbereich (5) elektrisch isolierten zweiten elektrischen Anschlussbereich (6), die jeweils einen Teil des Kontaktrahmens (3) und einen Teil des Kontaktträgers (4) umfassen, wobei
der Kontaktrahmen (3) mit einer Vertiefung (7) versehen ist, welche den ersten elektrischen Anschlussbereich (5) zumindest bereichsweise von dem zweiten elektrischen Anschlussbereich (6) trennt und in welche der optoelektronische Halbleiterchip (2) hineinragt, und wobei der Kontaktrahmen (3) mit einem Kontaktelement (30) ausgebildet ist, das den Kontaktrahmen (3) mit dem optoelektronischen Halbleiterchip (2) elektrisch verbindet.

2. Optoelektronisches Bauelement (1) nach Anspruch 1, wobei das Kontaktelement (30) ein Teil des ersten Anschlussbereichs (5) ist und den optoelektronischen Halbleiterchip (2) mit dem ersten Anschlussbereich (5) drahtlos elektrisch verbindet.

3. Optoelektronisches Bauelement (1) nach einem der vorhergehenden Ansprüche, wobei der optoelektronische Halbleiterchip (2) auf dem Kontaktträger (4) des zweiten Anschlussbereichs (6) angeordnet ist und mit dem Kontaktträger (4) drahtlos elektrisch verbunden ist.

4. Optoelektronisches Bauelement (1) nach einem der vorhergehenden Ansprüche, wobei
der Kontaktrahmen (3) und der Kontaktträger (4) einstückig ausgebildet sind.

5. Optoelektronisches Bauelement (1) nach Anspruch 4, wobei der Kontaktrahmen (3) und der Kontaktträger (4) einstückig aus einem Metallblech gebildet sind.

6. Optoelektronisches Bauelement (1) nach einem der Ansprüche 1 bis 3, wobei
der Kontaktrahmen (3) und der Kontaktträger (4) zwei separate Elemente sind.

7. Optoelektronisches Bauelement (1) nach Anspruch 6, wobei der Kontaktrahmen (3) auf dem Kontaktträger (4) angeordnet ist.

8. Optoelektronisches Bauelement (1) nach Anspruch 6 oder 7, wobei
der Kontaktrahmen (3) zumindest bereichsweise auf den Kontaktträger (4) geklebt, eutektisch gebondet oder gelötet ist.

9. Optoelektronisches Bauelement (1) nach einem der Ansprüche 6 bis 8, wobei
der Kontaktrahmen (3) aus einem Metallblech gebildet ist.

10. Optoelektronisches Bauelement (1) nach einem der Ansprüche 6 bis 9, wobei der Kontaktträger (4) aus einem Metallblech gebildet ist.

11. Optoelektronisches Bauelement (1) nach einem der Ansprüche 6 bis 9, wobei der Kontaktträger (4) ein Substrat (15) mit mindestens einem elektrisch leitenden Bereich (16) aufweist, wobei das Substrat (15) ein Keramikmaterial, ein Halbleitermaterial oder ein Kunststoffmaterial enthält.

12. Optoelektronisches Bauelement (1) nach einem der vorhergehenden Ansprüche, wobei der Kontaktrahmen (3) auf einer dem Kontaktträger (4) zugewandten oder abgewandten Seite weitere Vertiefungen (8) aufweist.

13. Optoelektronisches Bauelement (1) nach einem der vorhergehenden Ansprüche, wobei der Verbund aus optoelektronischem Halbleiterchip (2), Kontaktrahmen (3) und Kontaktträger (4) in eine Umhüllung (11) eingebettet ist.

14. Optoelektronisches Bauelement (1) nach Anspruch 12 und 13, wobei die weiteren Vertiefungen (8) mit dem Umhüllungsmaterial gefüllt sind.

15. Optoelektronisches Bauelement (1) nach einem der vorhergehenden Ansprüche mit einem weiteren Halbleiterchip (17), wobei der Kontaktrahmen (3) ein weiteres Kontaktelement (30) aufweist, das mit dem weiteren Halbleiterchip (17) verbunden ist, und wobei der optoelektronische Halbleiterchip (2) und der weitere Halbleiterchip (17) seriell, parallel oder antiparallel verschaltet sind.

## Claims

1. Optoelectronic component (1) comprising
- an optoelectronic semiconductor chip (2),
- a contact frame (3),
- a contact carrier (4),
- a first electrical connection zone (5) and a second electrical connection zone (6) electrically insulated from the first electrical connection zone (5), which in each case comprise part of the contact frame (3) and part of the contact carrier (4), wherein
the contact frame (3) is provided with a recess (7), which separates the first electrical connection zone (5) at least in places from the second electrical connection zone (6) and into which the optoelectronic semiconductor chip (2) projects, and wherein the contact frame (3) is provided with a contact element (30), which connects the contact frame (3) electrically with the optoelectronic semiconductor chip (2).

2. The optoelectronic component (1) according to claim 1, wherein the contact element (30) is part of the first connection zone (5) and electrically connects the optoelectronic semiconductor chip (2) wirelessly with the first connection zone (5).

3. The optoelectronic component (1) according to any one of the preceding claims,
wherein the optoelectronic semiconductor chip (2) is arranged on the contact carrier (4) of the second connection zone (6) and is electrically connected wirelessly with the contact carrier (4).

4. The optoelectronic component (1) according to any one of the preceding claims,
wherein the contact frame (3) and the contact carrier (4) are of one-piece construction.

5. The optoelectronic component (1) according to claim 4,
wherein the contact frame (3) and the contact carrier (4) are made in one piece from sheet metal.

6. The optoelectronic component (1) according to any one of claims 1 to 3,
wherein the contact frame (3) and the contact carrier (4) are two separate elements.

7. The optoelectronic component (1) according to claim 6,
wherein the contact frame (3) is arranged on the contact carrier (4).

8. The optoelectronic component (1) according to claim 6 or claim 7,
wherein the contact frame (3) is adhesively bonded, eutectically bonded or soldered at least in places to the contact carrier (4).

9. The optoelectronic component (1) according to any one of claims 6 to 8,
wherein the contact frame (3) is made from sheet metal.

10. The optoelectronic component (1) according to any one of claims 6 to 9,
wherein the contact carrier (4) is made from sheet metal.

11. The optoelectronic component (1) according to any one of claims 6 to 9,
wherein the contact carrier (4) comprises a substrate (15) with at least one electrically conductive zone (16), wherein the substrate (15) contains a ceramic material, a semiconductor material or a plastics material.

12. The optoelectronic component (1) according to any one of the preceding claims,
wherein the contact frame (3) comprises further recesses (8) on a side facing or remote from the contact carrier (4).

13. The optoelectronic component (1) according to any one of the preceding claims,
wherein the assembly of optoelectronic semiconductor chip (2), contact frame (3) and contact carrier (4) is embedded in an encapsulation (11).

14. The optoelectronic component (1) according to claim 12 and claim 13,
wherein the further recesses (8) are filled with the encapsulation material.

15. The optoelectronic component (1) according to any one of the preceding claims with a further semiconductor chip (17),
wherein the contact frame (3) comprises a further contact element (30), which is connected with the further semiconductor chip (17), and wherein the optoelectronic semiconductor chip (2) and the further semiconductor chip (17) are connected in series, in parallel or in antiparallel.

## Revendications

1. Élément optoélectronique (1) présentant
- une puce à semi-conducteur (2) optoélectronique,
- un cadre de contact (3),
- un porte-contact (4),
- une première zone de connexion (5) électrique et une deuxième zone de connexion (6) électrique, électriquement isolée de la première zone de connexion (5) électrique, lesquelles comprennent respectivement une partie du cadre de contact (3) et une partie du porte-contact (4),
le cadre de contact (3) étant muni d'un approfondissement (7) lequel sépare au moins en partie la première zone de connexion (5) électrique de la deuxième zone de connexion (6) électrique et dans lequel fait saillie la puce à semi-conducteur (2) optoélectronique, et le cadre de contact (3) étant réalisé avec un élément de contact (30) qui relie de manière électrique le cadre de contact (3) à la puce à semi-conducteur (2) optoélectronique.

2. Élément optoélectronique (1) selon la revendication 1, l'élément de contact (30) étant une partie de la première zone de connexion (5) et reliant la puce à semi-conducteur (2) optoélectronique avec la première zone de connexion (5) de manière électrique sans fil.

3. Élément optoélectronique (1) selon l'une quelconque des revendications précédentes,
la puce à semi-conducteur (2) optoélectronique étant disposée sur le porte-contact (4) de la deuxième zone de connexion (6) et étant reliée au porte-contact (4) de manière électrique sans fil.

4. Élément optoélectronique (1) selon l'une quelconque des revendications précédentes,
le cadre de contact (3) et le porte-contact (4) étant réalisés d'une seule pièce.

5. Élément optoélectronique (1) selon la revendication 4,
le cadre de contact (3) et le porte-contact (4) étant formés d'une seule pièce dans une tôle métallique.

6. Élément optoélectronique (1) selon l'une quelconque des revendications 1 à 3,
le cadre de contact (3) et le porte-contact (4) étant deux éléments séparés.

7. Élément optoélectronique (1) selon la revendication 6,
le cadre de contact (3) étant disposé sur le porte-contact (4).

8. Élément optoélectronique (1) selon la revendication 6 ou 7,
le cadre de contact (3) étant, au moins en partie, collé, lié de manière eutectique ou soudé sur le porte-contact (4).

9. Élément optoélectronique (1) selon l'une quelconque des revendications 6 à 8,
le cadre de contact (3) étant formé dans une tôle métallique.

10. Élément optoélectronique (1) selon l'une quelconque des revendications 6 à 9,
le porte-contact (4) étant formé dans une tôle métallique.

11. Élément optoélectronique (1) selon l'une quelconque des revendications 6 à 9,
le porte-contact (4) présentant un substrat (15) comprenant au moins une zone (16) électroconductrice, le substrat (15) contenant une matière céramique, une matière semi-conductrice ou une matière plastique.

12. Élément optoélectronique (1) selon l'une quelconque des revendications précédentes,
le cadre de contact (3) présentant sur un côté tourné vers le porte-contact (4) ou détourné du porte-contact des approfondissements (8) supplémentaires.

13. Élément optoélectronique (1) selon l'une quelconque des revendications précédentes,
le composite constitué de la puce à semi-conducteur (2) optoélectronique, du cadre de contact (3) et du porte-contact (4) étant intégré dans un enrobage (11).

14. Élément optoélectronique (1) selon les revendications 12 et 13,
les approfondissements (8) supplémentaires étant remplis avec la matière d'enrobage.

15. Élément optoélectronique (1) selon l'une quelconque des revendications précédentes comprenant une puce semi-conductrice (17) supplémentaire, le cadre de contact (3) présentant un élément de contact (30) supplémentaire qui est relié à la puce à semi-conducteur (17) supplémentaire, et la puce à semi-conducteur (2) optoélectronique et la puce à semi-conducteur (17) supplémentaire étant connectées en série, en parallèle ou de manière antiparallèle.
